# EUROPEAN PATENT APPLICATION

(11) **EP 4 741 847 A1**
(43) Date of publication of application: **13.05.2026**
(21) Application number: 24922430.4
(22) Date of filing: 05.12.2024
(51) Int. Cl.: G01R 31/367, G01R 31/382, G01R 22/06, H01M 10/48

(54) **TEST DEVICE AND METHOD FOR POWER PREDICTION OF BATTERY MANAGEMENT SYSTEM**

(30) Priority: 01.02.2024 KR 20240015700
(71) Applicant: LG Energy Solution, Ltd., Seoul 07335 (KR)
(72) Inventor: EOM, Ji Hye, Daejeon 34122 (KR)
(74) Representative: Goddar, Heinz J.
(86) International application number: PCT/KR2024/019890
(87) International publication number: WO 2025/164921

(57) **Abstract**

The present disclosure relates to a test device and a test method for power prediction of a battery management system, and a power prediction test device testing power prediction of a battery management system according to an embodiment of the present disclosure may include: a database including a plurality of power map tables indicating power according to a state of charge (SOC) and a temperature; a test executor generating a plurality of power prediction conditions with a combination of a plurality of SOCs and a plurality of temperatures in a power map table for a battery device, to which the battery management system is applied, among the plurality of power map tables, providing the battery management system with each of the plurality of power prediction conditions and a power prediction instruction corresponding to the each power prediction condition, and receiving a plurality of power prediction values according to the plurality of power prediction conditions from the battery management system; and a test comparator comparing each of the plurality of power prediction values with a normal range defined by a plurality of reference power values in the power map table based on a power prediction condition corresponding to the respective power prediction values.

## Description

### [Technical Field]

### CROSS-REFERENCE TO RELATED APPLICATION

This application claims priority to and the benefit of Korean Patent Application No. 10-2024-0015700 filed in the Korean Intellectual Property Office on February 1, 2024, the entire contents disclosed a literature of the relevant Korean patent application of which are incorporated herein by reference.

The present disclosure relates to a device and a method for executing a test for power prediction of a battery management system.

### [Background Art]

A battery management system can store and execute a power prediction program to predict a power of a battery device. After the power prediction program is installed in the battery management system, it is necessary to verify whether the power prediction program operates normally. Such a power prediction verification test is performed by an operator. When the test is performed at a temperature of -10 degrees to 60 degrees at a rate of 5 degrees in a range of state of charge (SOC) of 0 to 100% at a rate of SOC of 1%, the operator has to repeat the same operation 1500 times.

In this way, in the conventional power prediction verification test, the number of test operations is very large, and a time required for the test is long. In addition, since a test operation is dependent on the operator, a test result may vary for each operator, and a reliability of the test result is not high.

### [Disclosure]

### [Technical Problem]

The present disclosure attempts to provide a test device and a test method for power prediction capable of executing a power prediction test of a battery management system.

### [Technical Solution]

An exemplary embodiment of the present disclosure provides a test device for power prediction of a battery management system which may include: a database including a plurality of power map tables indicating power according to a state of charge (SOC) and a temperature; a test executor generating a plurality of power prediction conditions with a combination of a plurality of SOCs and a plurality of temperatures in a power map table for a battery device, to which the battery management system is applied, among the plurality of power map tables, providing the battery management system with each of the plurality of power prediction conditions and a power prediction instruction corresponding to the each power prediction condition, and receiving a plurality of power prediction values according to the plurality of power prediction conditions from the battery management system; and a test comparator comparing each of the plurality of power prediction values with a normal range defined by a plurality of reference power values in the power map table based on a power prediction condition corresponding to the respective power prediction values.

The test comparator may determine a first power value corresponding to a second SOC increased by a unit SOC from a first SOC corresponding to the power prediction condition and a first temperature corresponding to the power prediction condition, a second power value corresponding to a third SOC decreased by the unit SOC from the first SOC and the first temperature, a third power value corresponding to the first SOC and a second temperature increased by a unit temperature from the first temperature, and a fourth power value corresponding to the first SOC and a third temperature decreased by the unit temperature from the first temperature in the power map table. The test comparator may determine the normal range with an upper limit value obtained by adding a predetermined margin to a maximum value among the first to fourth power values and a lower limit value obtained by subtracting a predetermined margin from a minimum value among the first to fourth power values.

The power map table may include a long-term discharge power map table, a short-term discharge power map table, a long-term charge power map table, and a short-term charge power map table, the long-term discharge power may be power generated when the battery device is discharged from a current SOC to a predetermined first reference SOC during a predetermined first period, the short-term discharge power may be power generated when the battery device is discharged from the current SOC to the first reference SOC during a second period shorter than the first period, the long-term charge power may be power required for the battery device to be charged from a current SOC to a predetermined second reference SOC during a predetermined third period, and the short-term charge power may be power required for the battery device to be charged from the current SOC to the second reference SOC during a fourth period shorter than the third period.

The test executor may transmit a plurality of long-term discharge power prediction conditions and long-term discharge prediction instructions in the long-term discharge power map table to the battery management system, and receive a plurality of long-term discharge power prediction values based on the plurality of long-term discharge power prediction conditions from the battery management system. For each of the plurality of long-term discharge power prediction values in the long-term discharge power map table, the test comparator may determine a first long-term discharge power value corresponding to a second SOC increased by a unit SOC from a first SOC corresponding to a long-term discharge power prediction condition for the each long-term discharge power prediction value and a first temperature corresponding to the long-term discharge power prediction condition, a second long-term discharge power value corresponding to a third SOC decreased by the unit SOC from the first SOC, and the first temperature, a third long-term discharge power value corresponding to the first SOC, and a second temperature increased by a unit temperature from the first temperature, and a fourth long-term discharge power value corresponding to the first SOC, and a third temperature decreased by the unit temperature from the first temperature. The test comparator may determine the normal range with an upper limit value obtained by adding a predetermined margin to a maximum value among the first to fourth long-term discharge power values and a lower limit value obtained by subtracting a predetermined margin from a minimum value among the first to fourth long-term discharge power values, and determine a pass when the each long-term discharge power prediction value is within the normal range and determine a fail when the each long-term discharge power prediction value is out of the normal range.

The test executor may transmit a plurality of short-term discharge power prediction conditions and short-term discharge prediction instructions in the short-term discharge power map table to the battery management system, and receive a plurality of short-term discharge power prediction values based on the plurality of short-term discharge power prediction conditions from the battery management system. For each of the plurality of short-term discharge power prediction values in the short-term discharge power map table, the test comparator may determine a first short-term discharge power value corresponding to a second SOC increased by a unit SOC from a first SOC corresponding to a short-term discharge power prediction condition for the each short-term discharge power prediction value and a first temperature corresponding to the short-term discharge power prediction condition, a second short-term discharge power value corresponding to a third SOC decreased by the unit SOC from the first SOC, and the first temperature, a third short-term discharge power value corresponding to the first SOC, and a second temperature increased by a unit temperature from the first temperature, and a fourth short-term discharge power value corresponding to the first SOC, and a third temperature decreased by the unit temperature from the first temperature. The test comparator may determine the normal range with an upper limit value obtained by adding a predetermined margin to a maximum value among the first to fourth short-term discharge power values and a lower limit value obtained by subtracting a predetermined margin from a minimum value among the first to fourth short-term discharge power values, and determine a pass when the each short-term discharge power prediction value is within the normal range and determine a fail when the each short-term discharge power prediction value is out of the normal range.

The test executor may transmit a plurality of long-term charge power prediction conditions and long-term charge prediction instructions in the long-term charge power map table to the battery management system, and receive a plurality of long-term charge power prediction values based on the plurality of long-term charge power prediction conditions from the battery management system. For each of the plurality of long-term charge power prediction values in the long-term charge power map table, the test comparator may determine a first long-term charge power value corresponding to a second SOC increased by a unit SOC from a first SOC corresponding to a long-term charge power prediction condition for the each long-term charge power prediction value and a first temperature corresponding to the long-term charge power prediction condition, a second long-term charge power value corresponding to a third SOC decreased by the unit SOC from the first SOC, and the first temperature, a third long-term charge power value corresponding to the first SOC, and a second temperature increased by a unit temperature from the first temperature, and a fourth long-term charge power value corresponding to the first SOC, and a third temperature decreased by the unit temperature from the first temperature. The test comparator may determine the normal range with an upper limit value obtained by adding a predetermined margin to a maximum value among the first to fourth long-term charge power values and a lower limit value obtained by subtracting a predetermined margin from a minimum value among the first to fourth long-term charge power values, and determine a pass when the each long-term charge power prediction value is within the normal range and determine a fail when the each long-term charge power prediction value is out of the normal range.

The test executor may transmit a plurality of short-term charge power prediction conditions and short-term charge prediction instructions in the short-term charge power map table to the battery management system, and receive a plurality of short-term charge power prediction values based on the plurality of short-term charge power prediction conditions from the battery management system. For each of the plurality of short-term charge power prediction values in the short-term charge power map table, the test comparator may determine a first short-term charge power value corresponding to a second SOC increased by a unit SOC from a first SOC corresponding to a short-term charge power prediction condition for the each short-term charge power prediction value and a first temperature corresponding to the short-term charge power prediction condition, a second short-term charge power value corresponding to a third SOC decreased by the unit SOC from the first SOC, and the first temperature, a third short-term charge power value corresponding to the first SOC, and a second temperature increased by a unit temperature from the first temperature, and a fourth short-term charge power value corresponding to the first SOC, and a third temperature decreased by the unit temperature from the first temperature. The test comparator may determine the normal range with an upper limit value obtained by adding a predetermined margin to a maximum value among the first to fourth long-term charge power values and a lower limit value obtained by subtracting a predetermined margin from a minimum value among the first to fourth long-term charge power values, and determine a pass when the each short-term charge power prediction value is within the normal range and determine a fail when the each short-term discharge power prediction value is out of the normal range.

The test comparator may generate a plurality of discharge power difference values between the long-term discharge power map table and the short-term discharge power map table, and compare a predicted discharge power difference, which is a difference between a long-term discharge power prediction value and a short-term discharge power prediction value under a condition of a first SOC and a first temperature provided by the battery management system, with a normal range to determine a pass and a fail. The test comparator may determine the normal range with a plurality of reference discharge power difference values based on the condition of the first SOC and the first temperature among the plurality of discharge power difference values.

The test comparator may determine a first discharge power difference value corresponding to a second SOC increased by a unit SOC from the first SOC and the first temperature, a second discharge power difference value corresponding to a third SOC decreased by the unit SOC from the first SOC, and the first temperature, a third discharge power difference value corresponding to the first SOC, and a second temperature increased by a unit temperature from the first temperature, and a fourth discharge power difference value corresponding to the first SOC, and a third temperature decreased by the unit temperature from the first temperature. The test comparator may determine the normal range with an upper limit value obtained by adding a predetermined margin to a maximum value among the first to fourth discharge power difference values and a lower limit value obtained by subtracting the predetermined margin from a minimum value among the first to fourth discharge power difference values.

The test comparator may generate a plurality of charge power difference values between the long-term charge power map table and the short-term charge power map table, and compare a predicted charge power difference, which is a difference between a long-term charge power prediction value and a short-term charge power prediction value under a condition of a first SOC and a first temperature provided by the battery management system, with a normal range to determine a pass and a fail. The test comparator may determine the normal range with a plurality of reference charge power difference values based on a condition of the first SOC and the first temperature among the plurality of charge power difference values.

The test comparator may determine a first charge power difference value corresponding to a second SOC increased by a unit SOC from the first SOC and the first temperature, a second charge power difference value corresponding to a third SOC decreased by the unit SOC from the first SOC, and the first temperature, a third charge power difference value corresponding to the first SOC, and a second temperature increased by a unit temperature from the first temperature, and a fourth charge power difference value corresponding to the first SOC, and a third temperature decreased by the unit temperature from the first temperature. The test comparator may determine the normal range with an upper limit value obtained by adding a predetermined margin to a maximum value among the first to fourth charge power difference values and a lower limit value obtained by subtracting the predetermined margin from a minimum value among the first to fourth charge power difference values.

Another exemplary embodiment of the present disclosure provides a test method for power prediction of a battery management system which may include: generating a plurality of power prediction conditions with a combination of a plurality of SOCs and a plurality of temperatures in a power map table; providing each of the plurality of power prediction conditions and a power prediction instruction corresponding to the each power prediction condition to the battery management system; receiving a plurality of power prediction values according to the plurality of power prediction conditions from the battery management system; and comparing each of the plurality of power prediction values with a normal range defined by a plurality of reference power values in the power map table based on a power prediction condition corresponding to the respective power prediction values.

The power prediction test method may further include: determining a first power value corresponding to a second SOC increased by a unit SOC from a first SOC corresponding to the power prediction condition and the first temperature corresponding to the power prediction condition, a second power value corresponding to a third SOC decreased by the unit SOC from the first SOC and the first temperature, a third power value corresponding to the first SOC and a second temperature increased by a unit temperature from the first temperature, and a fourth power value corresponding to the first SOC and a third temperature decreased by the unit temperature from the first temperature in the power map table. The power prediction test method may further include determining the normal range with an upper limit value obtained by adding a predetermined margin to a maximum value among the first to fourth power values and a lower limit value obtained by subtracting a predetermined margin from a minimum value among the first to fourth power values.

The power map table may include a long-term discharge power map table, a short-term discharge power map table, a long-term charge power map table, and a short-term charge power map table, the long-term discharge power may be power generated when the battery device is discharged from a current SOC to a predetermined first reference SOC during a predetermined first period, the short-term discharge power may be power generated when the battery device is discharged from the current SOC to the first reference SOC during a second period shorter than the first period, the long-term charge power may be power required for the battery device to be charged from a current SOC to a predetermined second reference SOC during a predetermined third period, and the short-term discharge power may be power required for the battery device to be charged from the current SOC to the first reference SOC during a fourth period shorter than the third period.

The power prediction test method may further include: generating a plurality of discharge power difference values between the long-term discharge power map table and the short-term discharge power map table; generating a predicted discharge power difference, which is a difference between a long-term discharge power prediction value and a short-term discharge power prediction value under a condition of a first SOC and a first temperature provided by the battery management system; determining a normal range with a plurality of reference discharge power difference values based on a condition of the first SOC and the first temperature among the plurality of discharge power difference values; and comparing the predicted discharge power difference with the normal range to determine a pass and a fail.

The determining of the normal range may include determining a first discharge power difference value corresponding to a second SOC increased by a unit SOC from the first SOC and the first temperature, a second discharge power difference value corresponding to a third SOC decreased by the unit SOC from the first SOC, and the first temperature, a third discharge power difference value corresponding to the first SOC, and a second temperature increased by a unit temperature from the first temperature, and a fourth discharge power difference value corresponding to the first SOC, and a third temperature decreased by the unit temperature from the first temperature, The determining of the normal range may include determining the normal range with an upper limit value obtained by adding a predetermined margin to a maximum value among the first to fourth discharge power difference values and a lower limit value obtained by subtracting the predetermined margin from a minimum value among the first to fourth discharge power difference values.

The power prediction test method may further include: generating a plurality of charge power difference values between the long-term charge power map table and the short-term charge power map table; generating a predicted charge power difference, which is a difference between a long-term charge power prediction value and a short-term charge power prediction value under a condition of a first SOC and a first temperature provided by the battery management system; determining a normal range with a plurality of reference charge power difference values based on a condition of the first SOC and the first temperature among the plurality of charge power difference values; and comparing the predicted charge power difference with the normal range to determine a pass and a fail.

The determining of the normal range may include determining a first charge power difference value corresponding to a second SOC increased by a unit SOC from the first SOC and the first temperature, a second charge power difference value corresponding to a third SOC decreased by the unit SOC from the first SOC, and the first temperature, a third charge power difference value corresponding to the first SOC, and a second temperature increased by a unit temperature from the first temperature, and a fourth charge power difference value corresponding to the first SOC, and a third temperature decreased by the unit temperature from the first temperature. The determining of the normal range may include determining the normal range with an upper limit value obtained by adding a predetermined margin to a maximum value among the first to fourth charge power difference values and a lower limit value obtained by subtracting the predetermined margin from a minimum value among the first to fourth charge power difference values.

### [Advantageous Effects]

According to exemplary embodiments of the present disclosure, a device and a method for power prediction testing can be provided, which are capable of executing a power prediction test of a battery management system.

### [Description of the Drawings]

FIG. 1 is a diagram illustrating a power prediction test device according to an exemplary embodiment.
FIG. 2 is a diagram illustrating power map tables for a battery device according to an exemplary embodiment.
FIG. 3 is a diagram for describing a method of determining a normal range according to an exemplary embodiment.
FIG. 4 is a diagram schematically illustrating a memory region storing a long-term discharge power prediction test result in a memory according to an exemplary embodiment.
FIG. 5 is a diagram illustrating a discharge power difference table and a charge power difference table stored in the memory according to an exemplary embodiment.
FIG. 6 is a diagram illustrating a predicted discharge power difference table and a predicted charge power difference table stored in the memory according to an exemplary embodiment.
FIG. 7 is a diagram for describing a method of determining a normal range according to an exemplary embodiment.
FIG. 8 is a flowchart illustrating a power prediction test method for testing power prediction in a battery management system according to an exemplary embodiment.
FIG. 9 is a flowchart illustrating a power prediction test method for testing discharge power prediction in the battery management system according to an exemplary embodiment.
FIG. 10 is a flowchart illustrating a power prediction test method for testing charge power prediction in the battery management system according to an exemplary embodiment.

### [Mode for Invention]

In describing an exemplary embodiment disclosed in the present disclosure, a detailed description of related known technologies will be omitted if it is determined that the detailed description makes the gist of the exemplary embodiment of the present disclosure unclear. Further, the accompanying drawings are provided for helping to easily understand exemplary embodiments disclosed in this specification, and the technical spirit disclosed in this specification is not limited by the accompanying drawings, and it will be appreciated that the present disclosure includes all of the modifications, equivalent matters, and substitutes included in the spirit and the technical scope of the present disclosure.

Terms including an ordinary number, such as first and second, are used for describing various constituent elements, but the constituent elements are not limited by the terms. The terms are used only to discriminate one constituent element from another constituent element.

It should be understood that, when it is described that a constituent element is "connected to" or "accesses" another constituent element, the constituent element may be directly connected to or access the other constituent element or a third constituent element may be present therebetween. In contrast, when it is described that a constituent element is "directly connected to" or "directly accesses" another constituent element, it is understood that no constituent element is present between the constituent element and another constituent element.

In the present application, it will be appreciated that terms "including" and "having" are intended to designate the existence of characteristics, numbers, steps, operations, constituent elements, and components described in the specification or a combination thereof, and do not exclude a possibility of the existence or addition of one or more other characteristics, numbers, steps, operations, constituent elements, and components, or a combination thereof in advance.

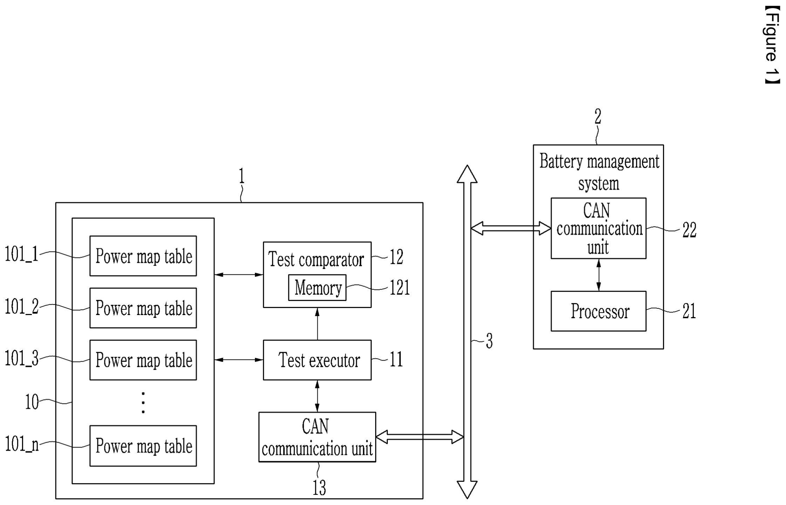

FIG. 1 is a diagram illustrating a power prediction test device according to an exemplary embodiment.

As illustrated in FIG. 1, a power prediction test device 1, and a battery management system 2 to be subjected to a power prediction test may transmit and receive information required for the test through CAN communication. As illustrated in FIG. 1, the CAN communication may be provided to the power prediction test device 1 and the battery management system 2 through a CAN bus 3.

The battery management system 2 may include a processor 21 and a CAN communication unit 22. A program for performing power prediction is installed in the processor 21, which may execute the power prediction according to a power prediction instruction and a power prediction condition received from the power prediction test device 1. The processor 21 may provide a prediction result to the CAN communication unit 22, and the CAN communication unit 22 may transmit the prediction result to the power prediction test device 1.

The predicted power may include charge power and discharge power. The charge power may refer to power required to charge a certain battery device from a current SOC to a predetermined reference SOC under a certain temperature condition. For example, the reference SOC may be 100%. The discharge power may refer to power that may be supplied when a certain battery device is discharged from the current SOC to the predetermined reference SOC under a certain temperature condition. A unit of power may be [kW]. The certain battery device may include a plurality of secondary battery cells connected in series. The charge power and the discharge power may vary depending on the battery device to which the battery management system 2 to be tested is applied.

The power prediction test device 1 may include a database 10, a test executor 11, a test comparator 12, and a CAN communication unit 13.

The database 10 may include a plurality of power map tables 101_1 to 101_n according to various types of battery devices. Each of the plurality of power map tables 101_1 to 101_n may include a table for each of the discharge power and the charge power according to the SOC and the temperature of the corresponding battery device. In addition, each of the plurality of power map tables 101_1 to 101_n may include a plurality of tables in which long-term discharge power and short-term discharge power, and long-term charge power and short-term charge power according to the SOC and the temperature of the corresponding battery device are matched. The "long-term" may be a period of 30 seconds or more, and the "short-term" may be a period of less than 30 seconds. The long-term discharge power is discharge power generated when discharging from the current SOC to the reference SOC (e.g., SOC 0%) during the 'long-term', and the short-term discharge power may be discharge power generated when discharging from the current SOC to the reference SOC (e.g., SOC 0%) during the 'short-term'. The long-term charge power is charge power required when charging from the current SOC to the reference SOC (e.g., SOC 100%) during the 'long-term', and the short-term charge power may be charge power required when charging from the current SOC to the reference SOC(e.g., SOC 100%) during the 'short-term'.

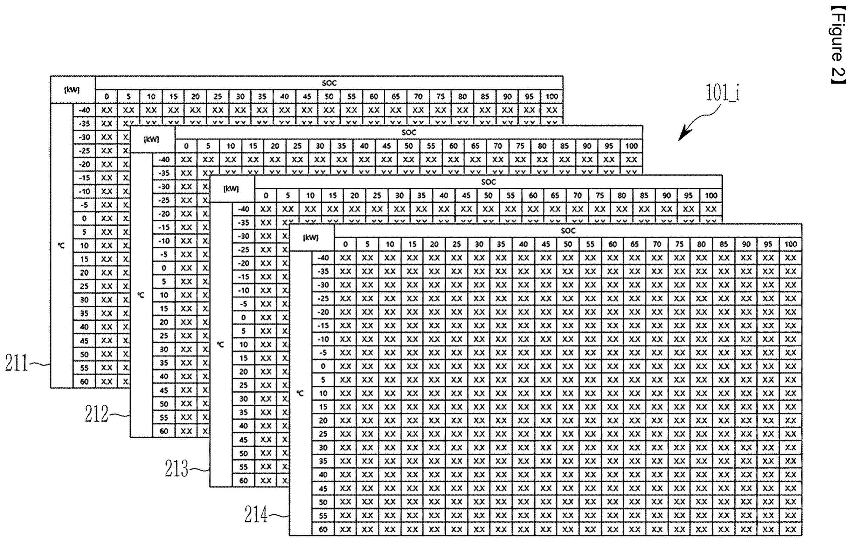

FIG. 2 is a diagram illustrating power map tables for a battery device according to an exemplary embodiment.

A power map table 101_i (i is a natural number of one of 1 to n) illustrated in FIG. 2 may be one of a plurality of power map tables 101_1 to 101_n illustrated in FIG. 1. The power map table 101_i may include a long-term discharge power map table 211, a short-term discharge power map table 212, a long-term charge power map table 213, and a short-term charge power map table 214. Each of the long-term discharge power map table 211, the short-term discharge power map table 212, the long-term charge power map table 213, and the short-term charge power map table 214 may be implemented as a table of a 21 × 21 matrix structure having 21 SOC columns divided by 5% in the range of SOC 0% to 100% and 21 temperature rows divided by 5°C. in the range of temperature -40°C. to 60°C. The power values in the long-term discharge power map table 211, the short-term discharge power map table 212, the long-term charge power map table 213, and the short-term charge power map table 214 illustrated in FIG. 2 are preset values, which are described as "x.x" in FIG. 2. "x.x" in FIG. 2 means a power value and may be determined according to an SOC and a temperature corresponding to the location. It should be noted that, hereinafter, "x.x" in this specification and the drawings is intended to indicate a power value determined according to a corresponding SOC and temperature, and is not used to indicate the same value.

In each of the long-term discharge power map table 211, the short-term discharge power map table 212, the long-term charge power map table 213, and the short-term charge power map table 214 illustrated in FIG. 2, the SOC, the temperature, and the power values corresponding to the SOC and the temperature may be obtained by the discharge power prediction program and the charge power prediction program. The discharge power prediction program is installed in the computing device, and the computing device receives the type of battery device, a discharge period (long-term or short-term), a current SOC and a current temperature of the battery device, and executes the discharge power prediction program according to input conditions, so as to predict the power value when the battery device is discharged from a current SOC of the battery device to a reference SOC. The charge power prediction program is installed in the computing device, and the computing device receives the type of battery device, a discharge period (long-term or short-term), a current SOC and a current temperature of the battery device, and executes the charge power prediction program according to input conditions, so as to predict a power value required for charging from the current SOC of the battery device to the reference SOC.

Programs which are the same as the discharge power prediction program and the charge power prediction program executed by the computing device may be installed in the processor 21. The processor 21 may receive a power prediction instruction, an SOC, and a temperature which are externally provided, and execute a program corresponding to the power prediction instruction from among a discharge power prediction program and a charge power prediction program by using the received SOC and temperature to predict one of the discharge power and the charge power. The power prediction instruction may indicate one of a long-term discharge power prediction instruction, a short-term discharge power prediction instruction, a long-term charge power prediction instruction, and a short-term charge power prediction instruction.

To verify the power prediction program, the test executor 11 may select a power map table (e.g., 101_i) from the database 10 for the battery device to which the battery management system 2 is applied. The test executor 11 may provide all power prediction conditions of each of the long-term discharge power map table 211, the short-term discharge power mapping table 212, the long-term charge power map table 213, and the short-term charge power map table 214 of the power map table 101_i to the battery management system 2, and match each of all power prediction results provided from the battery management system 2 with a corresponding power prediction condition to provide to the test comparator 12.

For example, the test executor 11 generates 21 x 21 long-term discharge power prediction conditions in all combinations between the SOC 0%, 5%, 10%, ..., 100% and the temperatures -40°C, -35°C, -30°C, ..., 60°C in the long-term discharge power map table 211 illustrated in FIG. 2, and sequentially provides each of all the long-term discharge power prediction conditions and a long-term discharge power prediction instruction to the CAN communication unit 13. The CAN communication unit 13 may transmit each of the long-term discharge power prediction condition and the long-term discharge power prediction instruction to the battery management system 2. According to the long-term discharge power prediction instruction and the long-term discharge power prediction condition received by the battery management system 2, the processor 21 may execute the discharge power prediction program to predict the long-term discharge power. The processor 21 may provide a long-term discharge power prediction value to the CAN communication unit 22, and the CAN communication unit 22 may transmit the long-term discharge power prediction value to the power prediction test device 1 through the CAN bus 3. The CAN communication unit 13 receives the long-term discharge power prediction value, and provides the received long-term discharge power prediction value to the test executor 11. The test executor 11 provides the long-term discharge power prediction condition and the long-term discharge power prediction value to the test comparator 12. The test comparator 12 may derive reference discharge power values in the long-term discharge power map table 211 based on the long-term discharge power prediction condition, and compare the long-term discharge power prediction value with a normal range defined by the derived reference discharge power values.

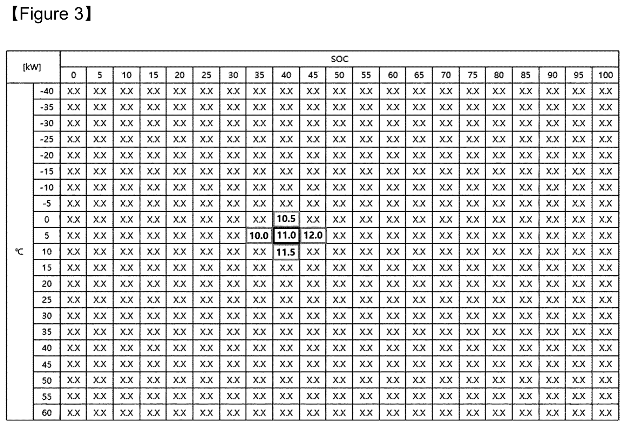

FIG. 3 is a diagram for describing a method of determining a normal range according to an exemplary embodiment.

In FIG. 3, exemplary values are described in some regions in the long-term discharge power map table 211. The values described in FIG. 3 as values for describing the exemplary embodiment may be different from actual power prediction values.

In FIG. 3, the test comparator 12 may derive a long-term discharge power value of 12.0 [kW] as high as a unit SOC (5%), a long-term discharge power value of 10.0 [kW] as low as a unit SOC, a long-term discharge power value of 11.5 [kW] as high as a unit temperature (5°C), and a long-term discharge power value of 10.5 [kW] as low as a unit temperature as reference discharge power values based on a long-term discharge power prediction condition (SOC 40% and 5°C), determine a normal range (9.0 to 13.0 [kW]) from a maximum reference value (13.0 [kW]) obtained by adding a predetermined margin (for example, 1.0 [kW] to a maximum value (12.0 [kW]) of the reference discharge power values and a minimum reference value (9.0 [kW]) obtained by subtracting a predetermined margin (for example, 1 [kW] from a minimum value (10.0 [kW]). The test comparator 12 may include a memory 121, and the test comparator 12 may store a result of comparing the normal range with the long-term discharge power prediction value received from the battery management system 2 in a corresponding memory cell. The test comparator 12 may determine a pass when the long-term discharge power prediction value is within the normal range, and determine a fail if the long-term discharge power prediction value is out of the normal range. When the fail occurs, it may be determined that there is an abnormality in the power prediction program installed in the processor 21 of the battery management system 2.

The memory 121 includes four memory regions, and the four memory regions may be divided into regions that store a long-term discharge power prediction test result, a short-term discharge power prediction test result, a long-term charge power prediction test result, and a short-term charge power prediction test result, respectively. Each memory region may include a plurality of memory cells defined in the same 21 × 21 matrix structure as the power map table. The test comparator 12 may store a result of comparing the long-term discharge power prediction value and the normal range in the memory cell corresponding to the power prediction condition.

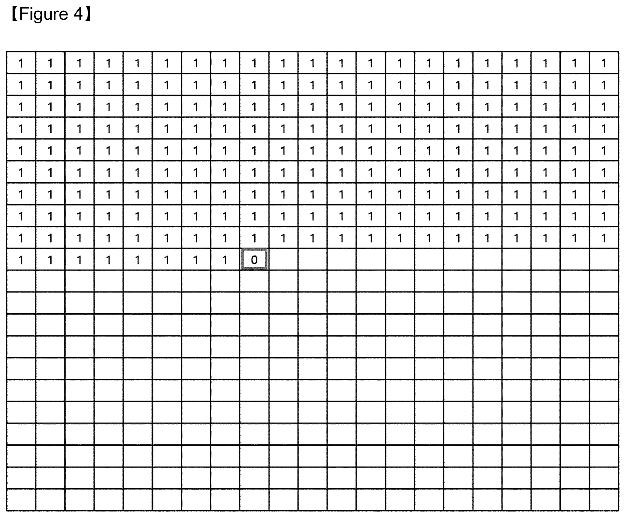

FIG. 4 is a diagram schematically illustrating a memory region storing a long-term discharge power prediction test result in a memory according to an exemplary embodiment.

The long-term discharge power prediction test result may be stored in a memory region 41 illustrated in FIG. 4. In each cell of the memory region 41, "1" may mean the pass and "0" may mean the fail. Cells in which a value of the memory region 41 is not described are cells in which a test result to be advanced is to be written. For example, the test comparator 12 may write "0" to a memory cell corresponding to an address 9 × 10 in the memory region 41 of the memory 121, assuming that a long-term discharge power prediction value according to a long-term discharge power prediction condition of the SOC 40% and the temperature 5°C is out of a normal range of 9.0 to 13.0 [kW].

The short-term discharge power prediction test, the long-term charge power prediction test, and the short-term charge power prediction test may be performed in the same scheme as the long-term discharge power prediction test.

For example, the test executor 11 generates 21 x 21 short-term discharge power prediction conditions in all combinations between the SOC 0%, 5%, 10%, ..., 100% and the temperatures -40°C, -35°C, -30°C, ..., 60°C in the short-term discharge power map table 212 illustrated in FIG. 2, and sequentially provides each of all the short-term discharge power prediction conditions and a short-term discharge power prediction instruction to the CAN communication unit 13. The CAN communication unit 13 may transmit each of the short-term discharge power prediction condition and the short-term discharge power prediction instruction to the battery management system 2. According to the short-term discharge power prediction instruction and the short-term discharge power prediction condition received by the battery management system 2, the processor 21 may execute the discharge power prediction program to predict the short-term discharge power. The processor 21 may provide a short-term discharge power prediction value to the CAN communication unit 22, and the CAN communication unit 22 may transmit the short-term discharge power prediction value to the power prediction test device 1 through the CAN bus 3. The CAN communication unit 13 receives the short-term discharge power prediction value, and provides the received short-term discharge power prediction value to the test executor 11. The test executor 11 provides the short-term discharge power prediction condition and the short-term discharge power prediction value to the test comparator 12. The test comparator 12 may derive reference discharge power values in the short-term discharge power map table 212 based on the short-term discharge power prediction condition, and compare the short-term discharge power prediction value with a normal range defined by the derived reference discharge power values. The test comparator 12 may write a value "1" indicating the pass to the memory cell of the corresponding memory region and address in the memory 121 when the short-term discharge power prediction value is within the normal range, and write a value "0" indicating the fail to the memory cell of the corresponding memory region and address in the memory 121 when the short-time discharge power prediction value is out of the normal range.

For example, the test executor 11 generates 21 x 21 long-term charge power prediction conditions in all combinations between the SOC 0%, 5%, 10%, ..., 100% and the temperatures -40°C, -35°C, -30°C, ..., 60°C in the long-term charge power map table 213 illustrated in FIG. 2, and sequentially provides each of all the long-term charge power prediction conditions and a long-term charge power prediction instruction to the CAN communication unit 13. The CAN communication unit 13 may transmit each of the long-term charge power prediction condition and the long-term charge power prediction instruction to the battery management system 2. According to the long-term charge power prediction instruction and the long-term charge power prediction condition received by the battery management system 2, the processor 21 may execute the charge power prediction program to predict the long-term charge power. The processor 21 may provide a long-term charge power prediction value to the CAN communication unit 22, and the CAN communication unit 22 may transmit the long-term charge power prediction value to the power prediction test device 1 through the CAN bus 3. The CAN communication unit 13 receives the long-term charge power prediction value, and provides the received long-term charge power prediction value to the test executor 11. The test executor 11 provides the long-term charge power prediction condition and the long-term charge power prediction value to the test comparator 12. The test comparator 12 may derive reference charge power values in the long-term charge power map table 213 based on the long-term charge power prediction condition, and compare the long-term charge power prediction value with a normal range defined by the derived reference charge power values. The test comparator 12 may write a value "1" indicating the pass to the memory cell of the corresponding memory region and address in the memory 121 when the long-term charge power prediction value is within the normal range, and write a value "0" indicating the fail to the memory cell of the corresponding memory region and address in the memory 121 when the long-time charge power prediction value is out of the normal range.

For example, the test executor 11 generates 21 x 21 short-term charge power prediction conditions in all combinations between the SOC 0%, 5%, 10%, ..., 100% and the temperatures -40°C, -35°C, -30°C, ..., 60°C in the short-term charge power map table 214 illustrated in FIG. 2, and sequentially provides each of all the short-term charge power prediction conditions and a short-term charge power prediction instruction to the CAN communication unit 13. The CAN communication unit 13 may transmit each of the short-term charge power prediction condition and the short-term charge power prediction instruction to the battery management system 2. According to the short-term charge power prediction instruction and the short-term charge power prediction condition received by the battery management system 2, the processor 21 may execute the charge power prediction program to predict the short-term charge power. The processor 21 may provide a short-term charge power prediction value to the CAN communication unit 22, and the CAN communication unit 22 may transmit the short-term charge power prediction value to the power prediction test device 1 through the CAN bus 3. The CAN communication unit 13 receives the short-term charge power prediction value, and provides the received short-term charge power prediction value to the test executor 11. The test executor 11 provides the short-term charge power prediction condition and the short-term charge power prediction value to the test comparator 12. The test comparator 12 may derive reference charge power values in the short-term charge power map table 214 based on the short-term charge power prediction condition, and compare the short-term charge power prediction value with a normal range defined by the derived reference charge power values. The test comparator 12 may write a value "1" indicating the pass to the memory cell of the corresponding memory region and address in the memory 121 when the short-term charge power prediction value is within the normal range, and write a value "0" indicating the fail to the memory cell of the corresponding memory region and address in the memory 121 when the short-time charge power prediction value is out of the normal range.

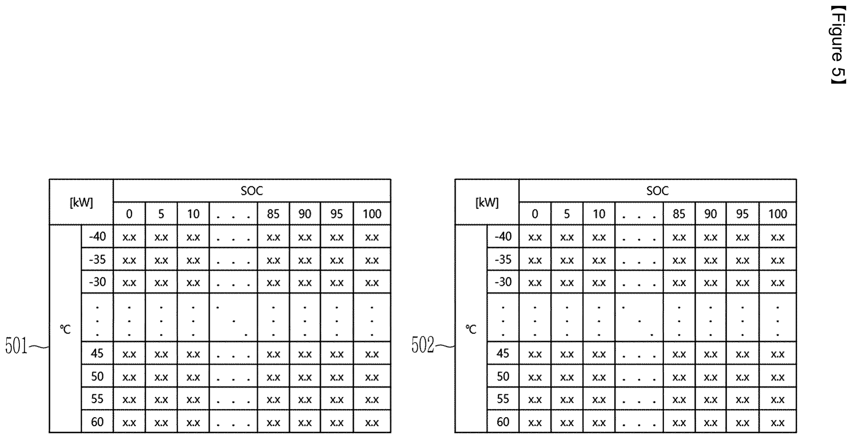

FIG. 5 is a diagram illustrating a discharge power difference table and a charge power difference table stored in the memory according to an exemplary embodiment.

The test comparator 12 may calculate a discharge power difference between corresponding power values in the long-term discharge power map table 211 and the short-term discharge power map table 212 to generate a discharge power difference table 501. The test comparator 12 may calculate a charge power difference between corresponding power values in the long-term charge power map table 213 and the short-term charge power map table 214 to generate a charge power difference table 502.

The test comparator 12 may store the discharge power difference table 501 and the charge power difference table 502 in the memory 121. The memory 121 may further include a memory region for storing the discharge power difference table 501 and the charge power difference table 502.

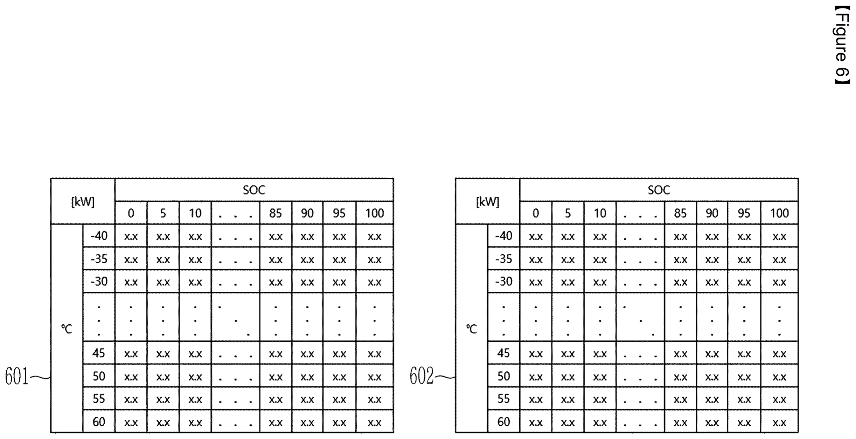

FIG. 6 is a diagram illustrating a predicted discharge power difference table and a predicted charge power difference table stored in the memory according to an exemplary embodiment.

The test comparator 12 may generate a predicted discharge power difference table 601 with a plurality of discharge power differences between a plurality of long-term discharge power prediction values and a plurality of short-term discharge power prediction values in a plurality of SOCs and a plurality of temperature conditions predicted by the battery management system 2 provided from the test executor 11. The test comparator 12 may generate a predicted discharge power difference table 602 with a plurality of charge power differences between a plurality of long-term charge power prediction values and a plurality of short-term charge power prediction values in the plurality of SOCs and the plurality of temperature conditions predicted by the battery management system 2 provided from the test executor 11. The test comparator 12 may store the predicted discharge power difference table 601 and the predicted charge power difference table 602 in the memory 121. The memory 121 may further include a memory region for storing the predicted discharge power difference table 601 and the predicted charge power difference table 602.

The test comparator 12 may compare each of all discharge power differences in the predicted discharge power difference table 601 to a normal range defined by corresponding reference discharge power difference values in the discharge power difference table 501. The test comparator 12 may compare each of all charge power differences in the predicted discharge power difference table 602 to a normal range defined by corresponding reference charge power difference values in the discharge power difference table 502.

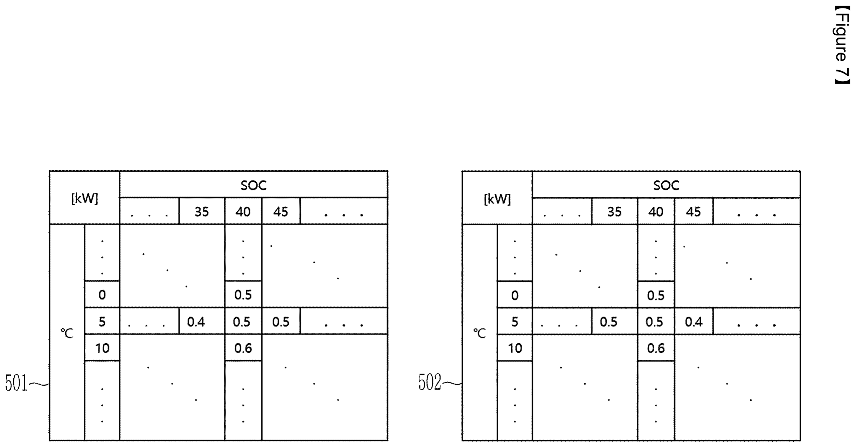

FIG. 7 is a diagram for describing a method of determining a normal range according to an exemplary embodiment.

FIG. 7 describes exemplary values in partial regions of each of the discharge power difference table 501 and the charge power difference table 502. The values described in FIG. 7 as values for describing the exemplary embodiment may be different from an actual discharge power difference and an actual charge power difference.

The test comparator 12 may derive the reference discharge power difference values corresponding to the predicted discharge power difference in the SOC 40% and temperature 5°C condition from the discharge power difference table 501. For example, based on a certain specific condition (SOC 40% and 5°C), a discharge power difference value of 0.5 [kW] as high as a unit SOC (5%), a discharge power differences value of 0.4 [kW] as low as the unit SOC, a discharge power difference value of 0.6 [kW] as high as a unit temperature (5°C), and a discharge power difference value of 0.5 [kW] as low as the unit temperature are derived as reference discharge power difference values. The test comparator 12 may determine the normal range (0.3 to 0.7 [kW]) with a maximum reference value (0.7 [kW]) obtained by adding a predetermined margin (e.g., 0.1 [kW]) to a maximum value (0.6 [kW]) and a minimum reference value (0.3 [kW]) obtained by subtracting a predetermined margin (e.g., 0.1 [kW]) from a minimum value (0.4 [kW]) among the reference discharge power difference values. The test comparator 12 may store a result of comparing the predicted discharge power difference value with the normal range in the corresponding memory cell in the memory 121. The test comparator 12 may determine the pass when the predicted discharge power difference value is within the normal range, and determine the fail when the predicted discharge power difference value is out of the normal range. For example, when the predicted discharge power difference at the SOC of 40% and the temperature of 5°C is 0.55 [kW], the test comparator 12 may determine the pass.

The test comparator 12 may derive the reference charge power difference values corresponding to the predicted charge power difference in the SOC 40% and temperature 5°C condition from the charge power difference table 502. For example, based on a certain specific condition (SOC 40% and 5°C), a charge power difference value of 0.4 [kW] as high as the unit SOC (5%), a charge power differences value of 0.5 [kW] as low as the unit SOC, a charge power difference value of 0.6 [kW] as high as a unit temperature (5°C), and a charge power difference value of 0.5 [kW] as low as the unit temperature are derived as reference charge power difference values. The test comparator 12 may determine the normal range (0.3 to 0.7 [kW]) with a maximum reference value (0.7 [kW]) obtained by adding a predetermined margin (e.g., 0.1 [kW]) to a maximum value (0.6 [kW]) and a minimum reference value (0.3 [kW]) obtained by subtracting a predetermined margin (e.g., 0.1 [kW]) from a minimum value (0.4 [kW]) among the reference charge power difference values. The test comparator 12 may store a result of comparing the predicted charge power difference value with the normal range in the corresponding memory cell in the memory 121. The test comparator 12 may determine the pass when the predicted charge power difference value is within the normal range, and determine the fail when the predicted charge power difference value is out of the normal range. For example, when the predicted charge power difference at the SOC of 40% and the temperature of 5°C is 0.65 [kW], the test comparator 12 may determine the pass.

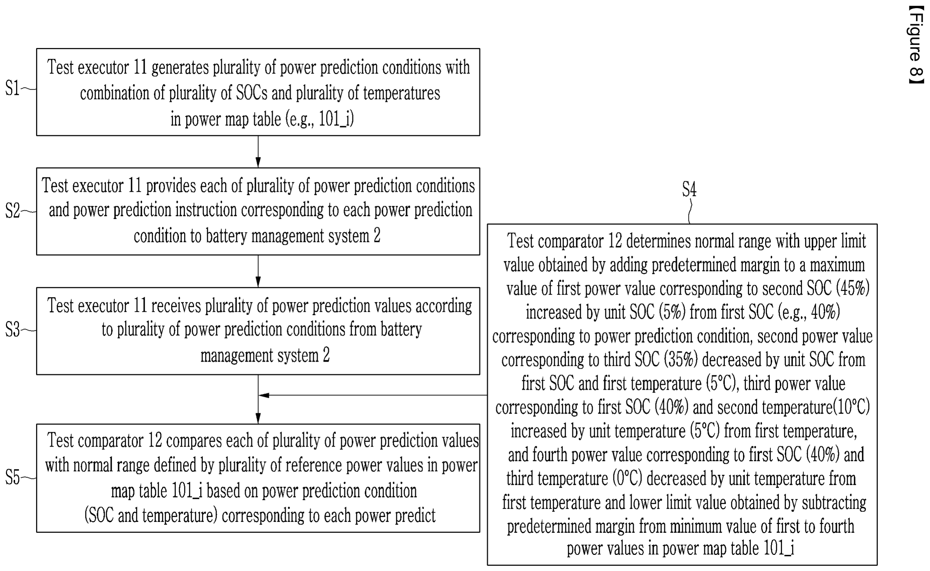

FIG. 8 is a flowchart illustrating a power prediction test method for testing power prediction in a battery management system according to an exemplary embodiment.

The test executor 11 may generate a plurality of power prediction conditions with a combination of a plurality of SOCs and a plurality of temperatures in the power map table (e.g., 101_i) (S1).

The test executor 11 may provide each of the plurality of power prediction conditions and a power prediction instruction corresponding to each power prediction condition to the battery management system 2 (S2).

The test executor 11 may receive a plurality of power prediction values according to the plurality of power prediction conditions from the battery management system 2 (S3).

The test comparator 12 may determine the normal range with an upper limit value obtained by adding a predetermined margin to a maximum value of a first power value corresponding to a second SOC (45%) increased by a unit SOC (5%) from a first SOC (e.g., 40%) corresponding to a power prediction condition, a second power value corresponding to a third SOC (35%) decreased by the unit SOC from the first SOC and the first temperature (5°C), a third power value corresponding to the first SOC (40%) and a second temperature (10° C.) increased by the unit temperature (5°C) from the first temperature, and a fourth power value corresponding to the first SOC (40%) and a third temperature (0°C) decreased by the unit temperature from the first temperature and a lower limit value obtained by subtracting a predetermined margin from a minimum value of the first to fourth power values in the power map table 101_i (S4).

The test comparator 12 may compare each of the plurality of power prediction values with the normal range defined by a plurality of reference power values in the power map table 101_i based on the power prediction condition (SOC and temperature) corresponding to each power prediction value (S5).

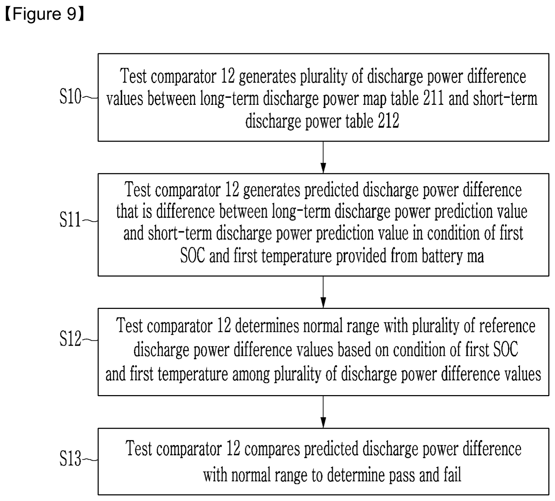

FIG. 9 is a flowchart illustrating a power prediction test method for testing discharge power prediction in the battery management system according to an exemplary embodiment.

The test comparator 12 may generate a plurality of discharge power difference values between the long-term discharge power map table (e.g., 211) and the short-term discharge power table (e. g., 212) (S10).

The test comparator 12 may generate a predicted discharge power difference that is a difference between the long-term discharge power prediction value and the short-term discharge power prediction value under the condition of the first SOC and the first temperature provided from the battery management system 2 (S11).

The test comparator 12 may determine the normal range with a plurality of reference discharge power difference values based on the condition of the first SOC and the first temperature among the plurality of discharge power difference values (S12). The test comparator 12 may determine the normal range of step S12 with an upper limit value obtained by adding a predetermined margin to a maximum value among a first discharge power difference value corresponding to a second SOC increased by a unit SOC from the first SOC and the first temperature, a second discharge power difference value corresponding to a third SOC decreased by the unit SOC from the first SOC, and the first temperature, a third discharge power difference value corresponding to the first SOC, and a second temperature increased by a unit temperature from the first temperature, and a fourth discharge power difference value corresponding to the first SOC, and a third temperature decreased by the unit temperature from the first temperature, and a lower limit value obtained by subtracting the predetermined margin from a minimum value among the first to fourth discharge power difference values.

The test comparator 12 may compare the predicted discharge power difference with the normal range to determine a pass and a fail (S13).

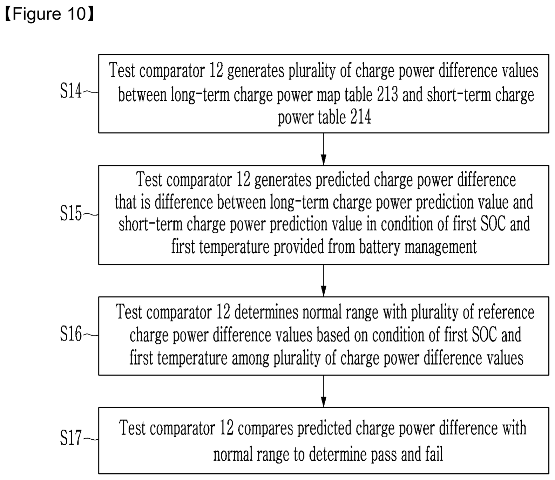

FIG. 10 is a flowchart illustrating a power prediction test method for testing charge power prediction in the battery management system according to an exemplary embodiment.

The test comparator 12 may generate a plurality of charge power difference values between the long-term charge power map table 213 and the short-term charge power table 214 (S14).

The test comparator 12 may generate a predicted charge power difference that is a difference between the long-term charge power prediction value and the short-term charge power prediction value under the condition of the first SOC and the first temperature provided from the battery management system 2 (S15).

The test comparator 12 may determine the normal range with a plurality of reference charge power difference values based on condition of the first SOC and the first temperature among the plurality of charge power difference values (S16). The test comparator 12 may determine the normal range of step S16 with an upper limit value obtained by adding a predetermined margin to a maximum value among a first charge power difference value corresponding to a second SOC increased by a unit SOC from the first SOC and the first temperature, a second charge power difference value corresponding to a third SOC decreased by the unit SOC from the first SOC, and the first temperature, a third charge power difference value corresponding to the first SOC, and a second temperature increased by a unit temperature from the first temperature, and a fourth charge power difference value corresponding to the first SOC, and a third temperature decreased by the unit temperature from the first temperature, and a lower limit value obtained by subtracting the predetermined margin from a minimum value among the first to fourth charge power difference values.

The test comparator 12 may compare the predicted charge power difference with the normal range to determine a pass and a fail (S17).

As described above, in order to test whether the power prediction program installed in the battery management system operates normally, an embodiment may automatically provide power prediction conditions to the battery management system, and receive power prediction results from the battery management system to determine one of the pass and the fail. Accordingly, a device and a method for power prediction test may be provided, which may perform an automated power prediction test without relying on an operator.

While this invention has been described in connection with what is presently considered to be practical exemplary embodiments, it is to be understood that the invention is not limited to the disclosed embodiments, but, on the contrary, is intended to cover various modifications and equivalent arrangements included within the spirit and scope of the appended claims.

## Claims

1. A power prediction test device testing power prediction of a battery management system, comprising:
a database including a plurality of power map tables indicating power according to a state of charge (SOC) and a temperature;
a test executor configured to generate a plurality of power prediction conditions with a combination of a plurality of SOCs and a plurality of temperatures in a power map table for a battery device, to which the battery management system is applied, among the plurality of power map tables, provide the battery management system with each of the plurality of power prediction conditions and a power prediction instruction corresponding to the each power prediction condition, and receive a plurality of power prediction values according to the plurality of power prediction conditions from the battery management system; and
a test comparator configured to compare each of the plurality of power prediction values with a normal range defined by a plurality of reference power values in the power map table based on a power prediction condition corresponding to the respective power prediction values.

2. The power prediction test device of claim 1, wherein:
the test comparator is configured to
determine a first power value corresponding to a second SOC increased by a unit SOC from a first SOC corresponding to the power prediction condition and a first temperature corresponding to the power prediction condition, a second power value corresponding to a third SOC decreased by the unit SOC from the first SOC and the first temperature, a third power value corresponding to the first SOC and a second temperature increased by a unit temperature from the first temperature, and a fourth power value corresponding to the first SOC and a third temperature decreased by the unit temperature from the first temperature in the power map table, and
determine the normal range with an upper limit value obtained by adding a predetermined margin to a maximum value among of the first to fourth power values and a lower limit value obtained by subtracting a predetermined margin from a minimum value among the first to fourth power values.

3. The power prediction test device of claim 1, wherein:
the power map table includes a long-term discharge power map table, a short-term discharge power map table, a long-term charge power map table, and a short-term charge power map table,
the long-term discharge power is power generated when the battery device is discharged from a current SOC to a predetermined first reference SOC during a predetermined first period of time,
the short-term discharge power is power generated when the battery device is discharged from the current SOC to the first reference SOC during a second period shorter than the first period,
the long-term charge power is power required for the battery device to be discharged from a current SOC to a predetermined second reference SOC during a predetermined third period of time, and
the short-term charge power is power required for the battery device to be charged from the current SOC to the second reference SOC during a fourth period shorter than the third period.

4. The power prediction test device of claim 3, wherein:
the test executor is configured to transmit a plurality of long-term discharge power prediction conditions and long-term discharge prediction instructions in the long-term discharge power map table to the battery management system, and receive a plurality of long term discharge power prediction values based on the plurality of long-term discharge power prediction conditions from the battery management system, and
the test comparator is configured to,
for each of the plurality of long-term discharge power prediction values in the long-term discharge power map table,
determine a first long-term discharge power value corresponding to a second SOC increased by a unit SOC from a first SOC corresponding to a long-term discharge power prediction condition for the each long-term discharge power prediction value and a first temperature corresponding to the long-term discharge power prediction condition, a second long-term discharge power value corresponding to a third SOC decreased by the unit SOC from the first SOC, and the first temperature, a third long-term discharge power value corresponding to the first SOC, and a second temperature increased by a unit temperature from the first temperature, and a fourth long-term discharge power value corresponding to the first SOC, and a third temperature decreased by the unit temperature from the first temperature,
determines the normal range with an upper limit value obtained by adding a predetermined margin to a maximum value among the first to fourth long-term discharge power values and a lower limit value obtained by subtracting a predetermined margin from a minimum value among the first to fourth long-term discharge power values, and
determine a pass when the each long-term discharge power prediction value is within the normal range and determines a fail when the each long-term discharge power prediction value is out of the normal range.

5. The power prediction test device of claim 3, wherein:
the test executor is configured to transmit a plurality of short-term discharge power prediction conditions and short-term discharge prediction instructions in the short-term discharge power map table to the battery management system, and receive a plurality of short term discharge power prediction values based on the plurality of short-term discharge power prediction conditions from the battery management system, and
the test comparator is configured to,
for each of the plurality of short-term discharge power prediction values in the short-term discharge power map table,
determine a first short-term discharge power value corresponding to a second SOC increased by a unit SOC from a first SOC corresponding to a short-term discharge power prediction condition for the each short-term discharge power prediction value and a first temperature corresponding to the short-term discharge power prediction condition, a second short-term discharge power value corresponding to a third SOC decreased by the unit SOC from the first SOC, and the first temperature, a third short-term discharge power value corresponding to the first SOC, and a second temperature increased by a unit temperature from the first temperature, and a fourth short-term discharge power value corresponding to the first SOC, and a third temperature decreased by the unit temperature from the first temperature,
determine the normal range with an upper limit value obtained by adding a predetermined margin to a maximum value among the first to fourth short-term discharge power values and a lower limit value obtained by subtracting a predetermined margin from a minimum value among the first to fourth short-term discharge power values, and
determine a pass when the each short-term discharge power prediction value is within the normal range and determines a fail when the each short-term discharge power prediction value is out of the normal range.

6. The power prediction test device of claim 3, wherein:
the test executor is configured to transmit a plurality of long-term charge power prediction conditions and long-term charge prediction instructions in the long-term charge power map table to the battery management system, and receive a plurality of long-term charge power prediction values based on the plurality of long-term charge power prediction conditions from the battery management system, and
the test comparator is configured to,
for each of the plurality of long-term charge power prediction values in the long-term charge power map table,
determines a first long-term charge power value corresponding to a second SOC increased by a unit SOC from a first SOC corresponding to a long-term charge power prediction condition for the each long-term charge power prediction value and a first temperature corresponding to the long-term charge power prediction condition, a second long-term charge power value corresponding to a third SOC decreased by the unit SOC from the first SOC, and the first temperature, a third long-term charge power value corresponding to the first SOC, and a second temperature increased by a unit temperature from the first temperature, and a fourth long-term charge power value corresponding to the first SOC, and a third temperature decreased by the unit temperature from the first temperature,
determine the normal range with an upper limit value obtained by adding a predetermined margin to a maximum value among the first to fourth long-term charge power values and a lower limit value obtained by subtracting a predetermined margin from a minimum value among the first to fourth long-term charge power values, and
determine a pass when the each long-term charge power prediction value is within the normal range and determines a fail when the each long-term charge power prediction value is out of the normal range.

7. The power prediction test device of claim 3, wherein:
the test executor is configured to transmit a plurality of short-term charge power prediction conditions and short-term charge prediction instructions in the short-term charge power map table to the battery management system, and receive a plurality of short-term charge power prediction values based on the plurality of short-term charge power prediction conditions from the battery management system, and
the test comparator is configured to,
for each of the plurality of short-term charge power prediction values in the short-term charge power map table,
determine a first short-term charge power value corresponding to a second SOC increased by a unit SOC from a first SOC corresponding to a short-term charge power prediction condition for the each short-term charge power prediction value and a first temperature corresponding to the short-term charge power prediction condition, a second short-term charge power value corresponding to a third SOC decreased by the unit SOC from the first SOC, and the first temperature, a third short-term charge power value corresponding to the first SOC, and a second temperature increased by a unit temperature from the first temperature, and a fourth short-term charge power value corresponding to the first SOC, and a third temperature decreased by the unit temperature from the first temperature,
determine the normal range with an upper limit value obtained by adding a predetermined margin to a maximum value among and a lower limit value obtained by subtracting a predetermined margin from a minimum value among the first to fourth long-term charge power values, and
determine a pass when the each short-term charge power prediction value is within the normal range and determines a fail when the each short-term charge power prediction value is out of the normal range.

8. The power prediction test device of claim 3, wherein:
the test comparator is configured to
generate a plurality of discharge power difference values between the long-term discharge power map table and the short-term discharge power map table,
compare a predicted discharge power difference, which is a difference between a long-term discharge power prediction value and a short-term discharge power prediction value under a condition of a first SOC and a first temperature provided by the battery management system, with a normal range to determine a pass and a fail, and
determine the normal range with a plurality of reference discharge power difference values based on the condition of the first SOC and the first temperature among the plurality of discharge power difference values.

9. The power prediction test device of claim 8, wherein:
the test comparator is configured to,
determine a first discharge power difference value corresponding to a second SOC increased by a unit SOC from the first SOC and the first temperature, a second discharge power difference value corresponding to a third SOC decreased by the unit SOC from the first SOC, and the first temperature, a third discharge power difference value corresponding to the first SOC, and a second temperature increased by a unit temperature from the first temperature, and a fourth discharge power difference value corresponding to the first SOC, and a third temperature decreased by the unit temperature from the first temperature, and
determine the normal range with an upper limit value obtained by adding a predetermined margin to a maximum value among the first to fourth discharge power difference values and a lower limit value obtained by subtracting the predetermined margin from a minimum value among the first to fourth discharge power difference values.

10. The power prediction test device of claim 3, wherein:
the test comparator is configured to
generate a plurality of charge power difference values between the long-term charge power map table and the short-term charge power map table,
compare a predicted charge power difference, which is a difference between a long-term charge power prediction value and a short-term charge power prediction value under a condition of a first SOC and a first temperature provided by the battery management system, with a normal range to determine a pass and a fail, and
determine the normal range with a plurality of reference charge power difference values based on a condition of the first SOC and the first temperature among the plurality of charge power difference values.

11. The power prediction test device of claim 10, wherein:
the test comparator is configured to,
determine a first charge power difference value corresponding to a second SOC increased by a unit SOC from the first SOC and the first temperature, a second charge power difference value corresponding to a third SOC decreased by the unit SOC from the first SOC, and the first temperature, a third charge power difference value corresponding to the first SOC, and a second temperature increased by a unit temperature from the first temperature, and a fourth charge power difference value corresponding to the first SOC, and a third temperature decreased by the unit temperature from the first temperature, and
determine the normal range with an upper limit value obtained by adding a predetermined margin to a maximum value among the first to fourth charge power difference values and a lower limit value obtained by subtracting the predetermined margin from a minimum value among the first to fourth charge power difference values.

12. A power prediction test method testing power prediction of a battery management system, comprising:
generating a plurality of power prediction conditions with a combination of a plurality of SOCs and a plurality of temperatures in a power map table;
providing the battery management system with each of the plurality of power prediction conditions and a power prediction instruction corresponding to the each power prediction condition;
receiving a plurality of power prediction values according to the plurality of power prediction conditions from the battery management system; and
comparing each of the plurality of power prediction values with a normal range defined by a plurality of reference power values in the power map table based on a power prediction condition corresponding to the respective power prediction values.

13. The power prediction test method of claim 12, further comprising:
determining a first power value corresponding to a second SOC increased by a unit SOC from a first SOC corresponding to the power prediction condition and the first temperature corresponding to the power prediction condition, a second power value corresponding to a third SOC decreased by the unit SOC from the first SOC and the first temperature, a third power value corresponding to the first SOC and a second temperature increased by a unit temperature from the first temperature, and a fourth power value corresponding to the first SOC and a third temperature decreased by the unit temperature from the first temperature in the power map table; and
determining the normal range with an upper limit value obtained by adding a predetermined margin to a maximum value among the first to fourth power values and a lower limit value obtained by subtracting a predetermined margin from a minimum value among the first to fourth power values.

14. The power prediction test method of claim 12, wherein:
the power map table includes a long-term discharge power map table, a short-term discharge power map table, a long-term charge power map table, and a short-term charge power map table,
the long-term discharge power is power generated when the battery device is discharged from a current SOC to a predetermined first reference SOC during a predetermined first period of time,
the short-term discharge power is power generated when the battery device is discharged from the current SOC to the first reference SOC during a second period shorter than the first period,
the long-term charge power is power required for the battery device to be charged from a current SOC to a predetermined second reference SOC during a predetermined third period of time, and
the short-term charge power is power required for the battery device to be charged from the current SOC to the second reference SOC during a fourth period shorter than the third period.

15. The power prediction test method of claim 14, further comprising:
generating a plurality of discharge power difference values between the long-term discharge power map table and the short-term discharge power map table;
generating a predicted discharge power difference, which is a difference between a long-term discharge power prediction value and a short-term discharge power prediction value under a condition of a first SOC and a first temperature provided by the battery management system;
determining a normal range with a plurality of reference discharge power difference values based on a condition of the first SOC and the first temperature among the plurality of discharge power difference values; and
comparing the predicted discharge power difference with the normal range to determine a pass and a fail.

16. The power prediction test method of claim 15, wherein:
the determining of the normal range includes,
determining a first discharge power difference value corresponding to a second SOC increased by a unit SOC from the first SOC and the first temperature, a second discharge power difference value corresponding to a third SOC decreased by the unit SOC from the first SOC, and the first temperature, a third discharge power difference value corresponding to the first SOC, and a second temperature increased by a unit temperature from the first temperature, and a fourth discharge power difference value corresponding to the first SOC, and a third temperature decreased by the unit temperature from the first temperature; and
determining the normal range with an upper limit value obtained by adding a predetermined margin to a maximum value among the first to fourth discharge power difference values and a lower limit value obtained by subtracting the predetermined margin from a minimum value among the first to fourth discharge power difference values.

17. The power prediction test method of claim 14, further comprising:
generating a plurality of charge power difference values between the long-term charge power map table and the short-term charge power map table;
generating a predicted charge power difference, which is a difference between a long-term charge power prediction value and a short-term charge power prediction value under a condition of a first SOC and a first temperature provided by the battery management system;
determining a normal range with a plurality of reference charge power difference values based on a condition of the first SOC and the first temperature among the plurality of charge power difference values; and
comparing the predicted charge power difference with the normal range to determine a pass and a fail.

18. The power prediction test method of claim 17, wherein:
the determining of the normal range includes,
determining a first charge power difference value corresponding to a second SOC increased by a unit SOC from the first SOC and the first temperature, a second charge power difference value corresponding to a third SOC decreased by the unit SOC from the first SOC, and the first temperature, a third charge power difference value corresponding to the first SOC, and a second temperature increased by a unit temperature from the first temperature, and a fourth charge power difference value corresponding to the first SOC, and a third temperature decreased by the unit temperature from the first temperature; and
determining the normal range with an upper limit value obtained by adding a predetermined margin to a maximum value among the first to fourth charge power difference values and a lower limit value obtained by subtracting the predetermined margin from a minimum value among the first to fourth charge power difference values.
